Europäisches Patentamt

European Patent Office

Office européen des brevets

(19)

(11) **EP 1 222 739 B1**

(12) **EUROPÄISCHE PATENTSCHRIFT**

(45) Veröffentlichungstag und Bekanntmachung des Hinweises auf die Patenterteilung:
**19.11.2003 Patentblatt 2003/47**

(21) Anmeldenummer: **00975795.6**

(22) Anmeldetag: **22.09.2000**

(51) Int Cl.⁷: **H03K 19/173**

(86) Internationale Anmeldenummer:
**PCT/DE00/03349**

(87) Internationale Veröffentlichungsnummer:
**WO 01/024368 (05.04.2001 Gazette 2001/14)**

(54) **REKONFIGURIERBARES GATE-ARRAY**

RECONFIGURABLE GATE ARRAY

CIRCUIT INTEGRE PREDIFFUSE RECONFIGURABLE

(84) Benannte Vertragsstaaten:
**DE FR GB IT**

(30) Priorität: **29.09.1999 DE 19946752**

(43) Veröffentlichungstag der Anmeldung:
**17.07.2002 Patentblatt 2002/29**

(73) Patentinhaber: **Infineon Technologies AG
81669 München (DE)**

(72) Erfinder:
 • **KRESS, Rainer
 85604 Pöring (DE)**

 • **BUCHENRIEDER, Klaus
 85521 Riemerling (DE)**

(74) Vertreter: **Repkow, Ines, Dr. Dipl.-Ing.
Jannig & Repkow
Patentanwälte
Klausenberg 20
86199 Augsburg (DE)**

(56) Entgegenhaltungen:
**EP-A- 0 790 706        WO-A-99/34515
DE-A- 19 807 872      US-A- 4 870 302
US-A- 4 935 734       US-A- 5 835 405**

**Beschreibung**

Die Erfindung betrifft ein rekonfigurierbares Gate-Array, mit einer Anzahl von durch eine steuerbare Verdrahtung miteinander verbundenen und individuell steuerbaren Funktionsblöcken zur jeweiligen Ausführung einer bestimmten Funktion, mit einer Schnittstelle zu einer Daten- und Adressenkommunikation zwischen einem Prozessor und dem Gate-Array, und zum Zuführen von jeweils zur Steuerung der Funktionsblöcke und/oder deren Verdrahtung dienenden Konfigurationen aus einem Konfigurationsspeicher.

Ein rekonfigurierbares Gate-Array der genannten Art ist beispielsweise ein bekanntes anwenderprogrammierbares Gate-Array oder FPGA (Field Programmable Gate Array). Derartige FPGAs sind beispielsweise durch einen Baustein der XC62xx-Serie (xx = 09, 16, 36 oder 64) von XILINX® gegeben oder in Reiner W. Hartenstein, Viktor K. Prasanna: "Reconfigurable Architectures: High Performance by Configware", Itpress Verlag, D-76607 Bruchsal Germany, 1997 (ISBN 0-9639887-1-9) S. 147- 150 beschrieben.

Aus dem Dokument US-A-4 935 734 ist ein rekonfigurierbares Gate-Array bekannt, mit einer Anzahl von durch eine steuerbare Verdrahtung miteinander verbundenen und individuell steuerbaren. Funktionsblöcken zur jeweiligen Ausführung einer bestimmten Funktion, mit einer Schnittstelle zu einer Daten- und Adressenkommunikation zwischen einem Prozessor und dem Gate-Array, mit einer Schnittstelle zum Zuführen von jeweils zur Steuerung der Funktionsblöcke und/oder deren Verdrahtung dienenden Konfigurationen, und mit einer Pufferspeichereinrichtung zum wahlweisen Speichern der zugeführten Konfigurationen und zu einem direkten wahlweisen Zugriff auf jede in der Pufferspeichereinrichtung gespeicherte Konfiguration vom Gate-Array her.

Der Erfindung liegt die Aufgabe zu Grunde, ein Gate-Array der genannten Art bereitzustellen, mit dem prinzipiell größere Funktionen als bisher realisiert werden können.

Die Aufgabe wird durch ein rekonfigurierbares Gate-Array gelöst, das die im Anspruch 1 angegebenen Merkmale aufweist. Bevorzugte und vorteilhafte Ausführungsformen gehen aus den abhängigen Ansprüchen hervor.

Gemäß der im Anspruch 1 angegebenen Lösung ist vorteilhafterweise eine rekonfigurierbare, insbesondere dynamisch rekonfigurierbare integrierte Schaltung geschaffen, die auch in dem Fall, daß die Zahl der Funktions- bzw. Logikblöcke und/oder die Verdrahtungsressourcen für eine Realisierung einer größeren, industriell relevanten Schaltung und/oder Funktion zu klein ist, eine solche größere Schaltung und/oder Funktion noch realisieren kann.

Vorteilhafterweise sind bei dieser Lösung auch Funktionen, die auf ein als Coprozessor genutztes FPGA abgebildet sind und die nur schwer im Code eines Programms zu finden sind und während des Programmablaufs oft nur ineffizient dynamisch auf das FPGA nachgeladen werden können, bedeutend leichter zu finden.

Außerdem kann vorteilhafterweise eine dynamische Verschiebung von Funktionen auf einem FPGA, die bei einem herkömmlichen FPGA ohne Beeinträchtigung der Gesamtfunktion schwierig ist, leichter durchgeführt werden.

Uberdies ist die Ersetzung von wenig oder nicht genutzten Funktionen oder LRU-Funktionen (LRU steht für Least recently used), die in einem in einen vom FPGA getrennten Cache-Mechanismus mit besonderem externen Speicher nur schwierig zu realisieren ist, bedeutend leichter zu realisieren.

Das erfindungsgemäße Gate-Array ist auch vorteilhaft gegenüber bisher zu einer Lösung der vorstehend genannten Probleme vorgeschlagenen Lösungen, die in den folgenden Punkten zusammengefaßt werden können:

Große Schaltungen oder Funktionen werden partitioniert und die Funktionalität wird auf mehrere integrierte Schaltungen aufgeteilt, oder die Schaltungen oder Funktionen werden partitioniert und die Funktionalität wird zeitlich aufgeteilt, d.h., es wird die Möglichkeit genutzt, die integrierten Schaltungen zu rekonfigurieren. Die Strategie zum Rekonfigurieren sowie deren Zeitpunkt legt der Benutzer im Voraus fest.

Funktionen, die durch automatische Placement- und Routing-Werkzeuge laufen, sind meist sehr unregelmäßig aufgebaut. Eine Nachladestrategie wird von den Werkzeugen nicht berücksichtigt und ist somit nur unter großem Aufwand zu realisieren.

Das gleiche gilt für eine Nachladestrategie.

Ein spezieller Konfigurationsanschluß, der geeignet wäre, einen Caching-Mechanismus zu implementieren, ist meist nicht vorhanden. Einige Bausteine haben serielle Anschlüsse, die zu langsam sind, oder der Konfigurationsanschluß benötigt die gleichen Ressourcen wie z.B. der Dateneingang.

Der Einsatz von Caching Strategien im Rekonfigurationscontroller eines Bausteins mit programmierbarer Zellstruktur ist aus Dokument DE-A-198 07 872 bekannt.

Weitere Vorteile des erfindungsgemäßen Gate-Arrays sind darin zu sehen, daß

- auf einem dynamisch rekonfigurierbaren FPGA-Baustein, wie z.B. einem Baustein der XC62xx-Serie von XILINX®, durch den Pufferspeicher ein Caching-Mechanismus realisiert wird der vorzugs- und vorteilhafterweise direkt mitintegriert ist,

- Standardfunktionsmodule (Funktionsmakros) bereits bei der Compilation eines Programms erkannt und entsprechend in das lauffähige Programm (binär) eingebunden werden, wobei bereits während der Compilation im erzeugten Programmgraphen erkannt wird, welche Makros nicht mehr oder mit hoher Wahrscheinlichkeit sehr bald benötigt werden,

- die Makros an die CLB-Strukturen, die Geometrie der jeweiligen FPGAs (wie dies z.B. bei den Standardzellen der Fall war) und an die Routing-Ressourcen angepaßt sind,

- Makros aufgrund ihrer regulären Struktur sowohl lateral verschoben als auch dupliziert werden können,

- Ergebnisse in Registern des FPGA gehalten und nach dem Nachladen oder dem Verschieben einer Funktion direkt weiter verwendet werden können,

- Ein zweiter oder auch mehrere doppelportiger (dual-ported) Speicher über eine ebenfalls auf dem Chip integrierte DMA-Einrichtung (DMA steht für Direct Memory Access) somit dem SRAM (statischer Speicher mit wahlfreiem Zugriff) einer CLB-Einrichtung (CLB steht für Commanded Line Buffer) verbunden ist, daß Funktionsmakros vorgehalten werden können und somit eine verdeckte Rekonfiguration jederzeit unabhängig vom Status des Programms oder des gegenwärtig genutzten Teils der CLB-Einrichtung erfolgen kann, dynamisches Debugging während des Programmablaufs erfolgen kann, ohne daß der Programmablauf in jedweder Weise beeinträchtigt wird, und Registerwerte = Variablen entweder Punkt zu Punkt oder mehrfach verteilt werden können.

Die Erfindung ermöglicht vorteilhafterweise einen effizienten Einsatz von "speicher-organisierten" FPGAs für rekonfigurierbare Systeme z.B. im Bereich Custom Computing.

Die Erfindung wird in der nachfolgenden Beschreibung anhand der Zeichnungen beispielhaft näher erläutert. Es zeigen:

Figur 1   eine schematische Darstellung eines Ausführungsbeispiels eines erfindungsgemäßen Gate-Arrays,

Figur 2   einen Ausführungsbaum für beispielhafte Statements,

Figur 3   in schematischer Darstellung eine Implementierung der dem Ausführungsbaum entsprechenden Statements auf Funktionsmakros des erfindungsgemäßen Gate-Arrays,

Figur 4   in schematischer Darstellung die Implementierung nach Figur 3 bei Vorhandensein zusätzlicher Register,

Figur 5   ein Schieberegister zur Implementierung einer Schleife auf dem erfindungsgemäßen Gate-Array,

Figur 6   eine Schieberegister-Struktur für bestimmte Variablen einer speziellen Schleife und die für diese Schleife notwendigen Operatoren mit ihrer Verknüpfung zum Schieberegister und

Figur 7   die Schieberegister-Struktur nach Figur 6 als Funktionsmakros, wie sie direkt in das erfindungsgemäße Gate-Array implementiert werden kann.

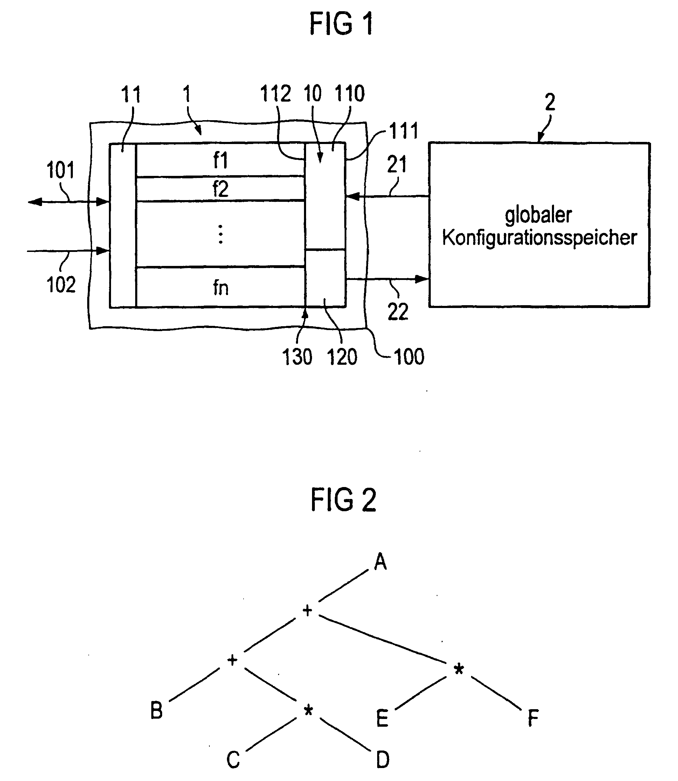

Das in der Figur 1 dargestellte rekonfigurierbare Gate-Array 1 weist eine Anzahl von durch eine nicht dargestellte steuerbare Verdrahtung miteinander verbundenen und individuell steuerbaren Funktionsblöcke $f_1, f_2, ..., f_n$ zur jeweiligen Ausführung einer bestimmten Funktion, beispielsweise eines Funktionsmakros, und eine Schnittstelle 11 zu einer Daten- und Adressenkommunikation zwischen einem nicht dargestellten Prozessor, vorzugsweise ein Prozessor, und dem Gate-Array 1 auf. Eine Datenleitung zur Übertragung von Daten zwischen dem Prozessor und der Schnittstelle 11 ist mit 101 und eine Adressenleitung zur Übertragung von Adressen vom Prozessor zur Schnittstelle 11 ist mit 102 bezeichnet. Die Schnittstelle 11 läßt das Gate-Array 1 wie ein Speicher über Adressen- und Datenleitungen 102, 101 ansprechen. Über diese Leitungen 101, 102 ist sowohl ein Datenaustausch als auch eine Umkonfigurierung möglich.

Außerdem können dem Gate-Array 1 aus einem Konfigurationsspeicher 2 Konfigurationen, beispielsweise Funktionsmakros, zugeführt werden, die jeweils zur Steuerung der Funktionsblöcke $f_1, f_2, ..., f_n$ und/oder deren Verdrahtung dienen. Konfigurationen werden über eine Leitung 21 vom Konfigurationsspeicher 2 zum Gate-Array 1 und Adressen über eine Leitung 22 vom Gate-Array 1 zum Konfigurationsspeicher 2 übertragen.

Das insbesondere dynamisch rekonfigurierbare Gate-Array 1 nach Figur 1 könnte in dieser Form beispielsweise ein FPGA-Baustein der XC62xx-Serie von XILINX® sein.

Erfindungsgemäß ist bei dem Gate-Array 1 nach Figur 1 eine vorzugsweise schnelle Pufferspeichereinrichtung 10 zum wahlweisen Speichern von Konfigurationen aus dem Konfigurationsspeicher 2 und zu einem direkten wahlweise Zugriff auf jede in der Pufferspeichereinrichtung 2 gespeicherte Konfiguration vom Gate-Array 1 her vorhanden. Der Zugriff vom Gate-Array 1 her auf die Pufferspeichereinrichtung 10 kann durch eine auf dem Halbleiterchip mit integrierte oder in einer eingehäusten Form untergebrachten DMA-Einrichtung 130.

Die Pufferspeichereinrichtung 10 ist vorzugsweise zusammen mit dem Gate-Array 1 auf einem gemeinsamen, in der Figur 1 nur bruchstückhaft dargestellten Halbleiterchip 100 integriert, auf dem auch der Konfigurationsspeicher 2 integriert sein kann.

Die Pufferspeichereinrichtung 10 ist vorzugsweise so ausgebildet, daß sie wenigstens doppelportigen bzw. dual-ported Speicher 110 mit einem Port 111 zum wahlweisen Zuführen von Konfigurationen aus dem Konfigurationsspeicher 2 und Speichern der zugeführten Konfigurationen in diesem Speicher 110 und mit einem anderen Port 112, über den das Gate-Array 1 direkten wahlweisen Zugriff auf jede im Speicher 110 gespeicherte Konfiguration hat. Der Speicher 110 weist vorzugsweise einen RAM, insbesondere einen statischen RAM bzw. SRAM auf.

Die Pufferspeichereinrichtung 10 weist überdies einen Rekonfigurationskontroller 120 auf, der nach einer Caching Strategie arbeitet, und wenig oder nicht genutzte Konfigurationen oder die zuletzt benutzte Konfiguration aus der Pufferspeichereinrichtung 10. herausnimmt, um Platz für neue Konfigurationen zu schaffen.

Durch die Pufferspeichereinrichtung 10 ist das Gate-Array 1 um einen Caching-Mechanismus erweitert, mit dem sich die eingangs erwähnten Probleme lösen lassen und durch den ein oder mehrere Konfigurationen, insbesondere Funktionsmakros FM vorgehalten werden können. Eine Rekonfiguration ist somit jederzeit unabhängig vom Status eines Programms oder der gegenwärtigen Ausnutzung der Funktions- oder Logikblöcke f1, f2, ..., fn aus der Pufferspeichereinrichtung 10 verdeckt möglich. Der Rechenbetrieb wird dadurch nicht beeinflußt. Dynamisches Debugging ist weiterhin während des Programmablaufs möglich. Die Funktionsmakros sind so gestaltet, daß sie aufgrund ihrer regulären Struktur sowohl lateral verschoben als auch dupliziert werden können. Zwischenergebnisse einer Rechnung können dabei in Registern des Gate-Arrays gehalten werden, um sie nach dem Nachladen oder Verschieben einer Funktion direkt weiterzuverwenden.

Über den Port 111 des Speichers 110 können weitere Konfigurationen oder Funktionsmakros geladen werden, um den Speicher 110 aufzufüllen. Für die Konfiguration des Gate-Arrays 1 kann eine ähnliche Struktur erhalten werden, wie sie bei Speichern üblich ist mit onchip Cache (first level), second level Cache, Hauptspeicher und Festplatte.

Da die Pufferspeichereinrichtung 10 von der Größe her begrenzt ist, müssen nach einiger Zeit Funktionsmakros aus dem der Pufferspeichereinrichtung 10 herausgenommen werden, um Platz für neue Funktionsmakros zu schaffen. Hierfür werden Caching Strategien genutzt.

Eine mögliche Strategie für die Umkonfigurierung des Konfigurationsspeichers 2 ist, diejenigen Funktionsmakros zuerst auszulagern, die zeitlich zuletzt genutzt wurden. Wird ein Funktionsmakro ausgelagert, welches später noch einmal benötigt wird, so muß es wieder geladen werden (Cache-Miss). Dies kostet Zeit für die Konfiguration. Um die Cache-Miss-Rate zu verkleinern wird jedem Funktionsmakro ein Zähler zugeordnet. Bei jeder Nutzung des Funktionsmakros wird ein Zähler um 1 erniedrigt. Wird der Zähler mit der Anzahl der Schleifendurchläufe geladen, so kann man ein Funktionsmakro, dessen Zählerstand als kleiner 1 ist, gefahrlos auslagern. Bei datenabhängigen Schleifen wird der Zähler auf einen Erfahrungswert gesetzt. Die Caching-Strategie wird bei dem Gate-Array 1 vom Rekonfigurationskontroller 120 ausgeführt.

Das Implementieren Statements auf dem Gate-Array 1 geschieht durch die Abbildung des Ausführungsbaums des Statements auf das Gate-Array 1.

Ein Statement wie beispielsweise

$$A = B + C * D + E * F$$

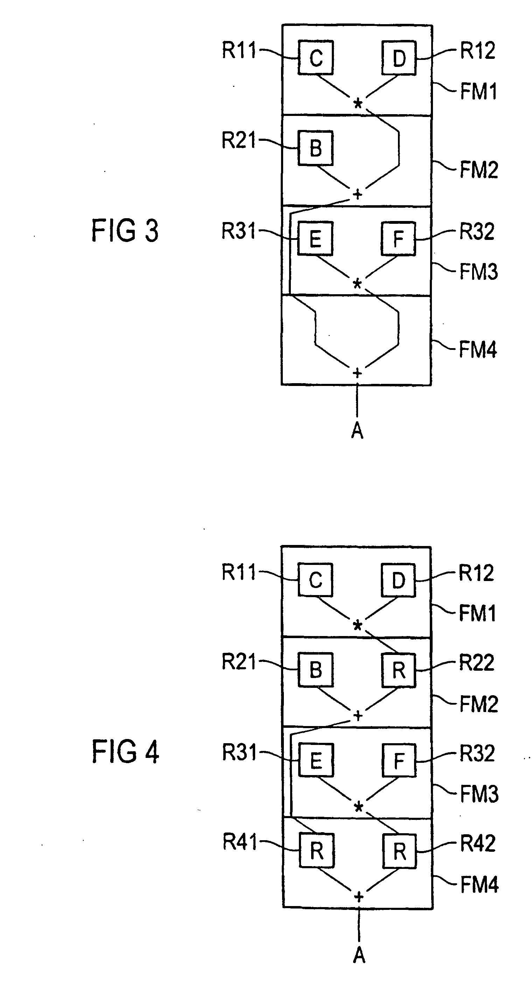

(A, B, C, D, E und F sind Zahlenwerte, + bedeutet Addition, * bedeutet Multiplikation) und wird entsprechend dem in Figur 2 dargestellten Ausführungsbaum in die in Figur 3 dargestellten vier Funktionsmakros FM1, FM2, FM3 und FM4 zerlegt.

Das Funktionsmakro FM1 besteht aus zwei Registern R11 und R12, die direkt von außen über Adress- und Datenleitungen ladbar sind. Der Inhalt der Register R11 und R12 wird multipliziert und das Ergebnis in das Funktionsmakro FM2 geschoben. Dort wird das Register R21 mit B geladen und mit dem weitergeschobenen Ergebnis aus dem Funktionsmakro FM1 1 addiert. Das neue Ergebnis wird in das Funktionsmakro FM4 geschoben. Das Funktionsmakro FM4 addiert dieses Ergebnis mit dem Ergebnis aus dem Funktionsmakro FM3, das aus zwei Registern R31 und R32 besteht, die direkt von außen über Adress- und Datenleitungen ladbar sind und deren Inhalt multipliziert wird. Das Ergebnis aus Funktionsmakro FM4 stellt das Gesamtergebnis A dar.

Um bei diesem Beispiel eine Rekonfigurierung zu ermöglichen, können wie in Figur 4 dargestellt zusätzliche Register R22 bzw., R41 und R42 in das Funktionsmakro FM2 und das Funktionsmakro FM4 einführt werden, welche die Zwischenergebnisse speichern. Wird dann der Platz, den das Funktionsmakro FM1 im Gate-Array 1 belegt, wieder benötigt, so kann der Platz freigegeben werden, sobald das Funktionsmakro FM2 mit seiner Berechnung beginnt.

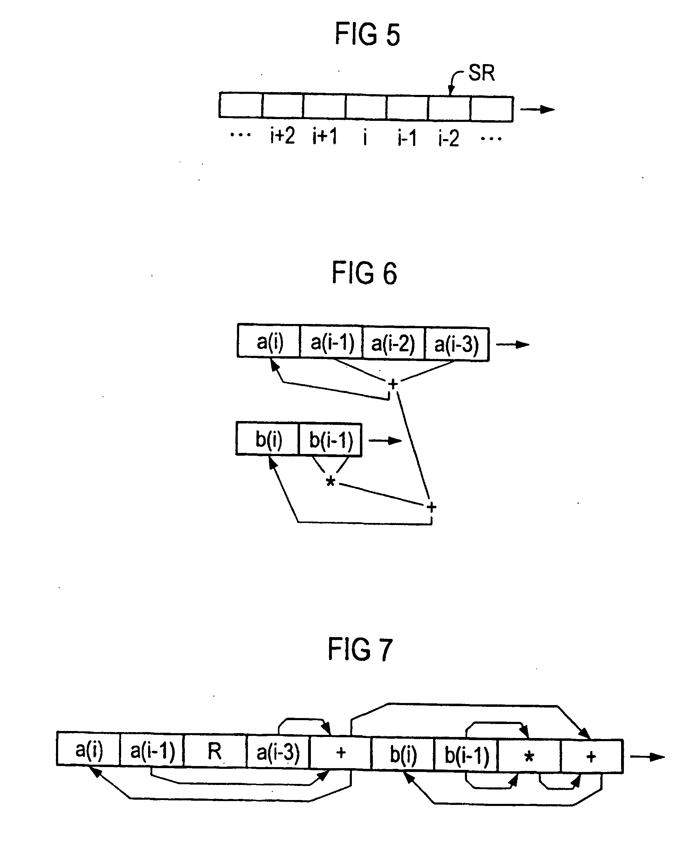

Beim Implementieren einer Schleife auf dem Gate-Array 1 werden durch Schieberegister interne Variablen wiederverwendet, was den Engpaß zum Datenspeicher reduziert. Jede verwendete Variable welche von einem Index i abhängt, erhält ein in Figur 5 dargestelltes Schieberegister SR. In dem Schieberegister SR entspricht jede Position einem Index i bzw. einem Offset ... i+2, i+1 oder i-1, i-2, ... zum Index i

Beim Hochzählen des Schleifenindex i um eine Konstante k, die in der Regel gleich 1 ist, wird das Schieberegister SR um k Stellen weitergeschoben. Die Operationen können so an festen Punkten am Schieberegister SR festgemacht werden. Um das Schieberegister SR mit den Operationen als Funktionsmakros darzustellen, wird das Schieberegister SR verteilt.

Die Vorgehensweise ist für die beispielhafte Schleife

```
for (i = 0; i < 100, i++){

a (i) = a (i-1) + a (i-3);

b (i) = b (i-1) * b (i-1) + a (i);}
```

in den Figuren 6 und 7 dargestellt.

Die Figur 6 zeigt die Schieberegister-Struktur für die Variable a, für die Variable b, sowie die notwendigen Operatoren + und * mit ihrer Verknüpfung zum Schieberegister SR.

Die Figur 7 zeigt die Lösung als Funktionsmakros, wie sie direkt in das Gate-Array implementiert werden kann. Nach jeder Berechnung wird das Schieberegister SR um k = 1 weitergeschoben und die nächste Berechnung findet statt. Die Bedingung zum Erkennen des Schleifenendes wird entweder auch im Gate-Array 1 (Index i inkrementieren und auf kleiner 100 abfragen) oder von einer externen Kontrolleinheit realisiert.

Falls das Gate-Array 1 dynamisch verwaltet werden soll, so ist es sinnvoll, die Lücken, die im Gate-Array 1 durch die Freigabe von Funktionsmakros entstehen, möglichst am Stück zur Verfügung zu haben. Dies dann erreicht werden, indem durch Schieben von Funktionsmakros ein Garbage Collect realisiert wird. Ein solcher Garbage Collect könnte als Prozeß in Software oder Firmware mit niedriger Priorität im Hintergrund laufen oder als spezielle Hardware auf dem Gate-Array 1 implementiert sein.

## Patentansprüche

1. Rekonfigurierbares Gate-Array (1),

   - mit einer Anzahl von durch eine steuerbare Verdrahtung miteinander verbundenen und individuell steuerbaren Funktionsblöcken (f1, f2, ..., fn) zur jeweiligen Ausführung einer bestimmten Funktion (FM),

   - mit einer Schnittstelle (11) zu einer Daten- und Adressenkommunikation zwischen einem Prozessor und dem Gate-Array (1),

   - mit einer Schnittstelle (111, 112) zum Zuführen von jeweils zur Steuerung der Funktionsblöcke (f1, f2, ..., fn) und/oder deren Verdrahtung dienenden Konfigurationen aus einem Konfigurationsspeicher (2), und

   - mit einer Pufferspeichereinrichtung (10) zum wahlweisen Speichern von Konfigurationen aus dem Konfigurationsspeicher (2) und zu einem direkten wahlweisen Zugriff auf jede in der Pufferspeichereinrichtung (10) gespeicherte Konfiguration vom Gate-Array (1) her, wobei die Pufferspeichereinrichtung (10) einen Rekonfigurationscontroller (120) enthält, der nach einer Caching Strategie arbeitet, und wenig oder nicht genutzte Konfigurationen oder die zuletzt benutzte Konfiguration aus der Pufferspeichezeinrichtung (10) herausnimmt, um Platz für neue Konfigurationen zu schaffen.

2. Gate-Array nach Anspruch 1,
   **dadurch gekennzeichnet,**
   **daß** die Pufferspeichereinrichtung (10) zusammen mit dem Gate-Array (1) auf einem gemeinsamen Halbleiter-Chip integriert ist.

3. Gate-Array nach Anspruch 1 oder 2,
   **dadurch gekennzeichnet,**
   **daß** die Pufferspeichereinrichtung (10) wenigstens einen doppelportigen Speicher (110) mit einem Port (111) zum wahlweisen Zuführen von Konfigurationen aus dem Konfigurationsspeicher (2) und Speichern der zugeführten Konfigurationen im doppelportigen Speicher (110) und mit einem anderen Port (112), über den das Gate-Array (1) direkten weilweisen Zugriff auf jede im doppelportigen Speicher (110) gespeicherte Konfiguration hat.

## Claims

1. Reconfigurable gate array (1),

   - having a number of function blocks (f1, f2, ..., fn), which are connected to one another via controllable wiring and can be controlled individually, for the respective execution of a specific function (FM),

   - having an interface (11) for data and address communication between a processor and the gate array (1),

   - having an interface (111, 112) to supply configurations, in each case needed to control the function blocks (f1, f2, .., fn) and/or their wiring, from a configuration memory (2), and

   - having a buffer memory device (10) for the selective storage of configurations from the configuration memory (2) and for direct selective access from the gate array (1) to any configuration stored in the buffer storage device (10) the buffer memory device (10) containing a reconfiguration controller (120) which operates in accordance with a caching strategy and removes little used or unused configurations or the configuration last used from the buffer memory device (10) in order to create space for new configurations.

**2.** Gate array according to Claim 1, **characterized in that** the buffer storage device (10) together with the gate array (1) is integrated on a common semiconductor chip.

**3.** The gate array (1) according to Claim 1 or 2, **characterized in that** the buffer storage device (10) [lacuna] at least one dual-ported memory (110) with a port (111) for the selective supply of configurations from the configuration memory (2) and storage of the configurations supplied in the double-ported memory (110), and with another port (112), via which the gate array (1) has direct selective access to any configuration stored in the dual-ported memory (110).

## Revendications

**1.** Circuit intégré prédiffusé reconfigurable (1),

- avec un certain nombre de blocs fonctionnels (f1, f2, ..., fn) servant à l'exécution respective d'une fonction déterminée (FM), pouvant être commandés individuellement et reliés entre eux par un câblage pouvant être commandé,

- avec une interface (11) assurant la communication de données et d'adresses entre un processeur et le circuit intégré prédiffusé (1),

- avec une interface (111, 112) pour la transmission, depuis une mémoire de configuration (2), des configurations respectivement servant à la commande des blocs fonctionnels (f1, f2, ..., fn) et/ou de leur câblage, et

- avec un dispositif de mémoire tampon (10) pour la mémorisation aléatoire de configurations issues de la mémoire de configuration (2) et pour un accès aléatoire direct, depuis le circuit intégré prédiffusé (1), à chaque configuration mémorisée dans le dispositif de mémoire tampon (10), le dispositif de mémoire tampon (10) comprenant un contrôleur de reconfiguration (120) travaillant selon une stratégie d'antémémoire et qui retire les configurations peu ou pas utilisées, ou la dernière configuration utilisée, du dispositif de mémoire tampon (10) pour créer de la place pour de nouvelles configurations.

**2.** Circuit intégré prédiffusé selon la revendication 1, **caractérisé en ce que** le dispositif de mémoire tampon (10) est intégré avec le circuit intégré prédiffusé (1) sur une puce à semi-conducteurs commune.

**3.** Circuit intégré prédiffusé selon la revendication 1 ou 2, **caractérisé en ce que** le dispositif de mémoire tampon (10) comporte au moins une mémoire à double accès (110) avec un port (111) pour la transmission aléatoire de configurations depuis la mémoire de configurations (2) et la mémorisation des configurations transmises dans la mémoire à double accès (110), et avec un autre port (112) permettant au circuit intégré prédiffusé (1) un accès aléatoire direct à chaque configuration mémorisée dans la mémoire à double accès (110).

# FIG 1

f1

f2

⋮

fn

101

102

11   1

112  10  110

111

21

22

130  120

100

globaler
Konfigurationsspeicher

2

# FIG 2

A

+

+

*

B

*

E

F

C

D

FIG 3

FIG 4

# FIG 5

# FIG 6

# FIG 7